# EUROPEAN PATENT APPLICATION

(11) **EP 4 174 956 A1**
(43) Date of publication of application: **03.05.2023**
(21) Application number: 22204597.3
(22) Date of filing: 29.10.2022
(51) Int. Cl.: H01L 29/778, H01L 29/41, H01P 1/15, H01L 29/423, H01L 29/20

(54) **A HIGH FREQUENCY SWITCH WITH FIELD EFFECT TRANSISTOR**

(30) Priority: 29.10.2021 EP 21461612
(71) Applicant: Instytut Wysokich Cisnien Polskiej Akademii Nauk, 01-142 Warszawa (PL); POLITECHNIKA WARSZAWSKA, 00-661 Warszawa (PL)
(72) Inventor: Cywinski, Grzegorz, 02-843 Warszawa (PL); Rumiantcev, Sergei, 02-703 Warszawa (PL); Bajurko, Pawel, 02-495 Warszawa (PL); Yashchyshyn, Yevhen, 05-506 Lesznowola (PL)
(74) Representative: Bury & Bury

(57) **Abstract**

A high frequency switch with a field effect transistor having a source (101) and drain (102) connected with a channel (103) having a first conductivity type covered with a gate having a gate electrode (105) and a gate insulator layer (104) between the gate electrode and the channel. The gate electrode has a second conductivity type opposite to the first conductivity type.

## Description

### Field of the invention

The invention concerns a high frequency switch with field effect transistor especially for switching microwave, millimeter wave and higher frequency signals.

### State of the art

Radio frequency (RF) and terahertz dynamically reconfigurable multi-element devices often require electronic switches. Efficient switches are important components for the development of new communication, sensing, imaging, testing, and instrumentation systems. Applications of such switches include switched-beam reconfigurable antennas, polarization switching, multi-band receivers, transceivers, time division duplexing systems, and test circuits with multiple signal paths.

There is a number of technologies available for millimeter-wave switches. Most of them employ transistors based on typical semiconductor manufacturing technologies using silicon or III-V semiconductors e.g known from publications of:
- Kim, J.; Kim, S.; Song K.; Rieh, J. A 300-GHz SPST Switch With a New Coupled-Line Topology in 65-nm CMOS Technology. IEEE Transactions on Terahertz Science and Technology, vol. 9, no. 2, pp. 215-218, March 2019, doi: 10.1109/TTHZ.2019.2898815;
- Song, P.; Schmid, R. L.; Ulusoy, A. C.; Cressler, J. D. A high-power, low-loss W-band SPDT switch using SiGe PIN diodes. 2014 IEEE Radio Frequency Integrated Circuits Symposium, Tampa, FL, 2014, pp. 195-198, doi: 10.1109/RFIC.2014.6851695.
- Yashchyshyn, Y.; Marczewski, J.; Tomaszewski, D. Investigation of the S-PIN Diodes for Silicon Monolithic Antennas with Reconfigurable Aperture. IEEE Transactions on Microwave Theory and Techniques, vol. 58, Issue 5, May 2010, pp. 1100-1106, doi: 10.1109/TMTT.2010.2045523.
- Yashchyshyn, Y.; Marczewski, J.; Derzakowski, K.; Modelski, J.; Grabiec, P. Development and Investigation of an Antenna System With Reconfigurable Aperture. IEEE Transactions on Antennas and Propagation, vol. 57, Issue 1, Jan. 2009, pp. 2-8;
- Yashchyshyn, Y.; Derzakowski, K.; Bajurko, P.; Marczewski, J.; Kozlowski, S. Time Modulated Reconfigurable Antenna Based on Integrated S-PIN Diodes for mm-Wave Communication Systems. IEEE Trans. on Antennas and Propagation. vol. 63, no. 9, 2015, pp. 4121-4131, doi: 10.1109/TAP.2015.2444425, or
- Yashchyshyn, Y.; Derzakowski, K.; Bogdan, G.; Godziszewski, K.; Nyzovets, D.; Kim, C. H.; Park, B. 28 GHz Switched-Beam Antenna Based on S-PIN Diodes for 5G Mobile Communications. IEEE Antennas and Wireless Prop. Letters, vol. 17, no. 2, pp. 225-228, 2018.
- From the art there are also known less conventional technologies of swithing, such as micro-electro-mechanical systems (MEMS) known from publications by Tolunay Wipf, S.; Göritz, A.; Wietstruck, M.; Wipf, C.; Tillack, B.; Kaynak, M. D-Band RF-MEMS SPDT Switch in a 0.13 µm SiGe BiCMOS Technology. IEEE Microwave and Wireless Components Letters, vol. 26, no. 12, pp. 1002-1004, Dec. 2016, doi: 10.1109/LMWC.2016.2623245, as well as Heredia, J. et al. A 125-143-GHz Frequency-Reconfigurable BiCMOS Compact LNA Using a Single RF-MEMS Switch. IEEE Microwave and Wireless Components Letters, vol. 29, no. 5, pp. 339-341, May 2019, doi: 10.1109/LMWC.2019.2906595.

In publications by Borodulin, P. et al. Recent advances in fabrication and characterization of GeTe-based phase-change RF switches and MMICs. 2017 IEEE MTT-S International Microwave Symposium (IMS), Honololu, HI, 2017, pp. 285-288, doi: 10.1109/MWSYM.2017.8059098 and by Hillman, C.; Stupar, P. A.; Hacker, J. B.; Griffith, Z.; Field, M.; Rodwell, M. An ultra-low loss millimeter-wave solid state switch technology based on the metal - insulator - transition of vanadium dioxide. 2014 IEEE MTT-S International Microwave Symposium (IMS2014), Tampa, FL, 2014, pp. 1-4, doi: 10.1109/MWSYM.2014.6848479, there were disclosed switches based on phase changing materials (PCM) .

Graphene has been applied to construct nanoelectromechanical systems (NEMS) - as disclosed e.g in Sharma, P.; Perruisseau-Carrier, J.; Ionescu, A. M. Nanoelectromechanical microwave switch based on graphene. 2013 14th International Conference on Ultimate Integration on Silicon (ULIS), Coventry, 2013, pp. 189-192, doi: 10.1109/ULIS.2013.6523516. The switches were based on a graphene membrane suspended over a specially constructed coplanar waveguide (CPW). When bias voltage was applied the membrane bent and created a short circuit in the waveguide.

European patent application EP3311412 discloses a HEMT cell including two or more gallium nitride ("GaN") high-electron-mobility transistor ("HEMT") devices electrically connected in series with each other. The HEMT cell includes a HEMT cell drain, a HEMT cell source, and a HEMT cell gate. The HEMT cell drain connects with the drain of a first GaN HEMT device in the series. The HEMT cell source connects with the source of a last GaN HEMT device in the series. The HEMT cell gate connects to a first two-dimensional electron gas ("2DEG") gate bias resistor that connects with the gate of the first GaN HEMT device. The HEMT cell gate connects to a second 2DEG gate bias resistor that connects with the gate of the second GaN HEMT device. The first and second 2DEG gate bias resistors are located in a 2DEG layer of the HEMT cell. A multi-throw RF switch is also disclosed.

### Problem to be solved

Conventional field effect transistors used for high frequency switching have parasitic capacitances between gate and other electrodes. Said patristic capacitances are of little consequence at low frequencies but above 1 GHz their impact increases and scattering parameters of switches such as transmittance, isolation and reflectance of the switches are severely deteriorated. At millimeter wavelengths parasitic capacitances make majority of field effect transistors unusable. It is an object of invention to reduce a negative impact of the capacitances on scattering parameters of the transistor switch especially in off-state of the transistor.

### Summary of the invention

Field effect transistor used in the switch according to the invention has a source and drain connected with a two-dimensional layer forming channel having a first conductivity type covered with a gate having gate electrode and a gate insulator layer between the gate electrode and the channel, according to the invention has the gate electrode which is a two-dimensional layer of material having a second conductivity type opposite to the first conductivity type. Opposite types of conductivity causes increase of gate resistance in transistor off-state. Consequently parasitic capacitances are blocked with increased resistance and therefore their contribution to transistor operation is reduced. 2-dimensional layers are commonly understood as layers having thickness of 10nm or less. Use of 2-dimensional layers causes the same potential to inject or push out charge carriers from both gate electrode and channel with the same voltage applied to the gate electrode.

The invention concerns a high frequency switch having a segment of high frequency transmission line having a first conductor and a second conductor, the switch having a transistor for either selective changing of resistance of either an interrupting gap provided between a parts of the first conductor - so calls series configuration or a gap between the first conductor and the second conductor - so called SHUNT configuration. According to the invention the transistor a source and a drain connected via a two-dimensional semiconducting layer forming a channel having a first conductivity type, a gate over the channel having gate electrode and a gate insulator layer provided between the gate electrode and the channel. The gate electrode is a two-dimensional semiconductor having a second conductivity type opposite to the first conductivity type. The transistor is arranged so that the two-dimensional semiconducting channel is disposed in either the interrupting gap provided between the parts of the first conductor or the spacing gap between the first conductor and the second conductor. The two-dimensional semiconducting gate electrode is disposed in the interrupting gap and connected to control electrode.

Advantageously the channel comprises electron gas having n-conductivity type and the gate electrode has a graphene layer having p-conductivity type.

The type of conductivity of graphene depends on the technological process of its production. In the described example, the graphene should have conductivity type p. The conductivity type of graphene can also change under the influence of an electric field. Advantageously in the example, the electric field does not change the conductivity type from p to the opposite. This configuration is very useful in the switches as when transistor channel is enriched and resistance of the channel is low then the resistance of the gate electrode is also low and on the other hand when the channel is depleted then the resistance of the gate electrode is high. This configuration enables improving both transmittance and reflectance in on-state of switch and isolation in off-state.

The segment of the transmission line is advantageously a segment of coplanar line having a substrate and a signal line forming the first conductor and two ground planes forming the second conductor disposed on the substrate. The signal line is interrupted and split into a first part and a second part. The transistor is integrated in the substrate of the segment of coplanar line below the interrupting gap so that the two-dimensional semiconductor gate electrode is disposed above the interrupting gap. The control electrode connects the gate electrode to either ground plane. It is series configuration in which the operation of the switch is controlled with voltage applied to the signal line. When the channel is depleted the gate electrode is resistivity is increased, therefore the isolation is improved in off-state of the switch. When the channel is enriched the gate electrode resistance is low and therefore transmittance is improved.

Advantageously the two-dimensional semiconducting gate electrode has two symmetrical control electrodes connected to both ground planes. Such configuration results in a more uniform channel of the transistor and therefore reduced reflectance of the switch.

Advantageously the segment of transmission line is a segment of the coplanar transmission line having a substrate and a signal line forming the first conductor and two ground planes forming the second conductor. The signal line is spaced by the spacing gaps from ground planes and the transistor is integrated in the substrate of the segment of coplanar line in the spacing gap between the signal line and at least one ground plane. The two-dimensional semiconductor channel is disposed between the signal line and the at least one of the ground planes. Above the channel, the two-dimensional semiconducting gate electrode having opposite conductivity type is provided. Although the invention is explained with reference to p-type conducting gate electrode and n-type conducting channel, it is noted that according to the invention other pairs of opposite types of two-dimensional semiconducting materials can be applied. The switch is controlled via gate electrode connected to the gate electrode. This is a switch in SHUNT configuration. When the channels are depleted the gate electrodes resistivity is increased, therefore reflectance and transmittance in on-state are improved as the characteristic impedance of the line is not affected. When channel is enriched and signal line is short circuited to the ground plane, the electrodes resistance is low and therefore isolation is improved.

Advantageously the two transistors are applied for short-circuiting the signal line to both ground planes simultaneously.

The spacing gaps and the signal line advantageously are narrowed down in the area in which the transistor is located.

### Description of drawings

The invention has been described below in detail, with reference to the following figures
- Fig. 1: showing schematically a structure of transistor according to embodiment of the invention;
- Fig. 2: showing schematically layer structure of the transistor according to the invention;
- Fig. 3: showing schematically layer structure of the transistor according to the invention in configuration convenient in manufacturing;
- Fig. 4: an embodiment of switch according to the invention implemented as CPW line with integrated transistor according to the invention;
- Fig .5a: another embodiment of switch according to the invention implemented as CPW line with integrated transistor according to the invention
- Fig. 5b: shows a microscopic photography of structure of the switch according to embodiment shown in Fig. 5a.
- Fig. 5c: shows measured and modelled parameters S11 and S21 in "on-state" of the switch according to the embodiment of the switch shown in Fig 5a and 5b.
- Fig. 5d: shows measured and modelled parameters S11 and S21 in "off-state" of the switch according to the embodiment of the switch shown in Fig 5a and 5b.
- Fig. 5e: shows comparison of S21 parameters measured in "on-state" and "off-state".
- Fig. 6: shows switch according to the invention in shunt configuration.
- Fig. 7: shows another embodiment of the switch according to the invention in shunt configuration.

### Embodiments of the invention

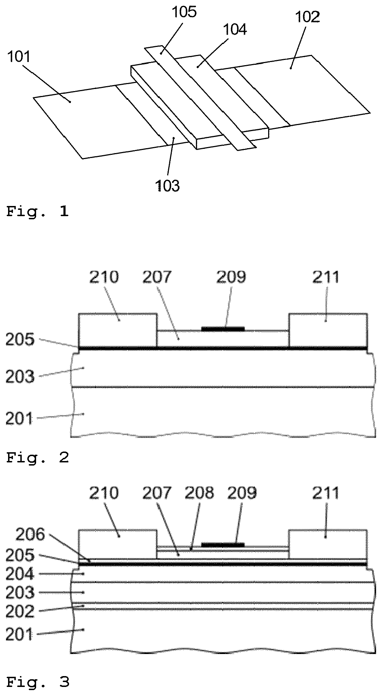

An embodiment of field effect transistor according to the invention is shown in Fig. 1a. It has a source **101** and drain **102** connected with a two-dimensional layer forming channel **103.** The channel **103** has n conductivity type. Above the channel there is provided a gate having gate electrode **105** and a gate insulator layer **104** provided between the gate electrode **105** and the channel **103,** characterized in that the gate electrode **105** is a layer of two-dimensional semiconducting material having p conductivity type, opposite to the conductivity type of the channel **103.** Alternatively the channel may be made of material having p-type conductivity and the gate electrode may be made of n-type conductivity.

The former configuration with n-type channel and p-type gate electrode may be implemented with a use of 2 dimensional electron gas as channel. This embodiment is shown in Fig. 2.

Transistor structure is formed on a substrate **201.** Above the substrate **201** an insulating GaN layer **203** is provided. Above the GaN layer **203** there is formed a layer of two-dimensional electron gas **205** which is a semiconductor having n-type of conductivity and forms a channel between a source **210** and a drain **211.** The electron gas layer **205** forming the channel is located below the source **210** and the drain **211.** Also between the drain **210** and the source **211** but above the electron gas layer **205** there is disposed an insulator - AlGaN barrier **207.** Above the AlGaN barrier **207** a two dimensional strip of two-dimensional p-type semiconducting graphene **209** is provided forming a gate electrode. Accordingly there is obtained a configuration according to the invention with the channel having a two-dimensional n-type semiconductor and gate electrode of opposite p-type two-dimensional semiconductor.

A configuration of the similar embodiment of the invention convenient in manufacturing is shown in Fig. 3.

The channel formed of two-dimensional electron gas **205** is generated between AlGaN spacer **206** and unintentionally doped (UID) GaN layer **204.** Unintentionally doped (UID) GaN layer **204** is provided on high-resistivity GaN **203** grown on AlN nucleation layer **202** on the c-plane 4H-SiC **201.** Source **210** and drain **211** are provided on AlGaN spacer **206.** Between source **210** and drain **211,** adjacent to AlGaN spacer **206** AlGaN barrier **207** is provided covered with GaN cap **208.** On the GaN cap **208** two dimensional layer **209** of graphene is provided.

Person skilled in the art knowing the teachings of the present invention can suggest configuration with channel implemented with p-type two-dimensional semiconductor and the gate made of two-dimensional n-type semiconductor.

RF switches, which use the combination of graphene and two dimensional electron gas (2DEG) in the AlGaN/GaN system are disclosed below. An embodiment working at frequency band from 10 MHz to 114.5 GHz is discussed.

The switches were integrated into the coplanar waveguide, which allows to use them in any systems without the use of e.g. bonding, flip-chip and other technologies and avoiding the matching problems.

The best switches exhibited the rise and fall switching times of ~25 ns and ~17 ns, respectively. The use of such a switch can provide up to 20 MHz of bandwidth in time-modulated systems, which is the outstanding result for such systems.

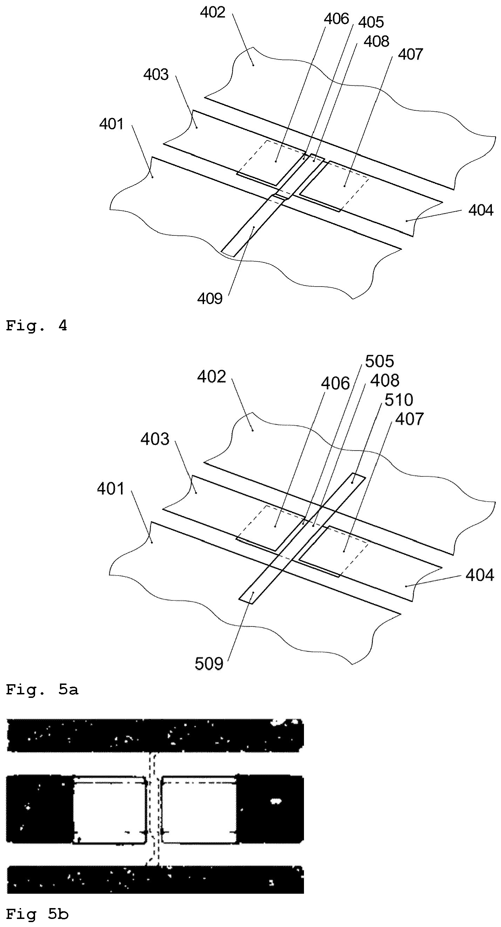

The present embodiment of the invention includes CPW with embedded Graphene/AlGaN/GaN switch made of transistor according to the invention switching signal CPW line. A typical CPW consists of two ground conductors and a signal conductor line in the middle. In the proposed structure, the signal conductor line is made of Ti/Al/Ni/Au on the top of the AlGaN/GaN structure. Structure of the switch according to this embodiment is shown schematically in Fig. 4 (substrate and technological layers not shown).

CPW line is defined by a first ground plane **401,** second ground plane **402** and a signal line having a first part **403** and a second part **404** disposed between the first ground plane **401** and the second ground plane **402.**

The signal line **403, 404** is interrupted with interrupting gap and transistor as described above is integrated in the interrupting gap between the first part **403** and the second part **404** of the signal line as shown in Fig. 4. A source **406** of said transistor according to the invention is connect to the first part **403** of the signal line and a drain **407** of said transistor according to the invention is connected to the second part **404** of the signal line. Accordingly, the first part **403** of the signal line and the second part of the signal line **404** are connected via channel **405** formed by 2DEG. Graphene layer **408** disposed above the channel forms a gate and is connected to control electrode **409.** Consequently a voltage applied to the control electrode **409** can be used to switch the transistor on and off and accordingly connect and disconnect parts **403, 404** of the signal line. The interrupting gap between the parts **403, 404** has low resistance when the transistor is in an on state and a high resistance when the transistor is in off state.

In the on-state, the connection between two parts **403, 404** of the signal line is provided by 2DEG. The graphene layer in the middle of the device, above 2DEG, acts as a gate. Control electrode **409** is isolated from the plane **401.** As a result, the structure operates as high frequency single pole, single throw (SPST) switch.

Applying negative voltage to the control electrode **409** disconnects parts **403, 404** of the signal lines.

Moreover, as opposed to conventional transistor-based design where metal gate is used, the properties of a graphene gate also change when the voltage is applied between the graphene gate and 2DEG. Therefore, the properties of both, 2DEG and graphene are controlled by the bias. In other words, 2DEG also can be considered as a "gate" relative to graphene. Since CVD graphene is of p-type conductivity, positive voltage on 2DEG relative to graphene reduces holes concentration and increases the graphene resistivity - same effect have been observed by Goniszewski, S., Adabi, M., Shaforost, O. et al. Correlation of p-doping in CVD Graphene with Substrate Surface Charges. Sci Rep 6, 22858 (2016), doi: 10.1038/srep22858. Therefore with properly designed graphene and two-dimensional electron gas at AlGaN/GaN interface, positive voltage on 2DEG relative to graphene can effectively remove the conductive layers in the central line interrupting gap of the CPW. This improved the off-state characteristics.

If control electrode **409** was grounded, then same effect could be obtaining setting positive potential on parts **403** and **404** of the signal line.

Embodiment of the switch according to the invention having two electrodes **509, 510** is shown in Fig. 5a. The switch can be improved if two control electrodes **509, 510** are applied instead of the single control electrode **409.** Moreover the control electrodes are grounded as the first control electrode **509** is connected with the first ground plane **401** and the second control electrode is connected with the second ground plane **402.** The graphene gate is connected to the ground (GND) of CPW, therefore the device is controlled by the bias voltage applied to the CPW signal pads along with high frequency signal. Distribution of the electrons in the electron gas forming a channel **505** visible in Fig. 5a is more uniform than in case of channel **405** according to embodiment described with reference to Fig. 4. Off state of the switch is set when positive potential is applied to parts **403** and **404** of the signal line.

Fig. 5b shows the optical microscope image of the fabricated switch according to the invention in configuration shown in Fig. 5a. Since graphene is barely seen in an optical microscope, its location is outlined with dashed lines.

The graphene/AlGaN/GaN layer of the switch shown in Fig. 5b has width of 10 µm. It is spaced from the drain and the source by 5 µm.

Specifically AlGaN/GaN epitaxial heterostructures grown by the Metalorganic Vapour Phase Epitaxy (MOVPE) on the silicon carbide substrate was applied. MOVPE growth was started from 38 nm thick AlN nucleation layer on the commercially available 500 µm thick semi-insulating SiC substrate. The next layer is 2.3 µm high resistivity (HR) GaN buffer followed by 0.7 µm unintentionally doped (UID) GaN layer. AlGaN barrier consists of: 1.2 nm AlₓGa₁₋ₓN (x = 66%), 5 nm AlₓGa₁₋ₓN UID (x = 28%), 10 nm AlGaN:Si (n~1.5·10¹⁸ cm⁻³), and 2 nm UID AlGaN layer. The whole heterostructure was covered by 2 nm GaN cap layer.

Although there is a parasitic capacitive coupling between 2DEG and grounded gate, it does not introduce low RF impedance to the ground in the on-state due to high resistivity of graphene.

The CPW processing was performed using a commercial laser writer system for lithography based on the 405 nm wavelength GaN laser source with 1 µm of minimum linewidth. The first step in the processing was 150 nm mesa etching provided by the Inductively Coupled Plasma-Reactive Ion Etching system. As a result of the etching, the 2DEG remained only under the signal line. Then, ohmic contacts were formed by thermal evaporation of Ti(15nm)/Al(100nm)/Ni(40nm)/Au(50nm) and rapid thermal annealing at 780°C for 1 minute under a N₂ atmosphere. Metallization for the ohmic contacts was deposited on the central line and interrupted in the middle. The ground lines were fabricated simultaneously. In order to be able to tune the width of the interrupting gap in the central line the same Ti/Al/Ni/Au metal stack may be deposited at a later time in order to reduce the interrupting gap width. This metal stack was not annealed.

The last step was graphene transferring and its patterning. Chemical vapour deposition (CVD) graphene layer was deposited on the whole GaN-based wafer by the high-speed electrochemical delamination technique - details of the process were given by Ciuk, T.; Pasternak, I.; Krajewska, A.; Sobieski, J.; Caban, P.; Szmidt, J.; Strupinski, W. in Properties of chemical vapor deposi-tion graphene transferred by high-speed electrochemical delamination. The Journal of Physical Chemistry C 2013, 117(40), 20833-20837. Detailed step-by-step procedure of the graphene delamination and transferring from Cu foil onto AlGaN/GaN can be found in report of Dub, M.; Sai, P.; Przewloka, A.; Krajewska, A.; Sakowicz, M.; Prystawko, P.; Kacperski, J.; Pasternak, I.; Cywinski, G.; But, D.; Knap, W.; Rumyantsev, S. Graphene as a Schottky Barrier Contact to AlGaN/GaN Heterostructures. Materials 2020, 13(18), 4140. Finally, graphene patterning was done by oxygen plasma etching.

During the CPW fabrication, the quality of the graphene layer was controlled with Raman spectroscopy.

The structure shown in Fig. 5b represent the field effect transistors with the left and right sides of the central line acting as the source and drain. The graphene layer in the middle, which is located between the source and drain on the top of the AlGaN barrier layer acts as a gate. It was shown previously that graphene forms a high quality Schottky barrier to AlGaN and graphene gate AlGaN/GaN transistors demonstrate very good characteristics.

On-chip S-parameter measurements of the Graphene/AlGaN/GaN switches in the 70.5-114.5 GHz frequency range were carried out using the measurement setup based on the Agilent N5245A PNA-X vector network analyzer (VNA) with VDI WR-10 waveguide frequency extenders and 100 µm pitch Cascade Microtech Infinity WR-10 waveguide GSG probes. The probes were positioned using the Cascade Microtech EPS200MMW probe station. For the measurements at frequencies below 50 GHz, the same setup was used but without frequency extenders and with coaxial GSG probes.

For the calibration and setting of the measurement plane to the contact pads, the SOLR Cascade 101-190C and LRM Cascade 138-357 standard impedance substrates were used at low and high frequencies, respectively. The S-parameter measurements were performed with bias voltages applied between the central lines and ground. The DC connections were provided through the bias ports of the VNA and through bias ports of the waveguide probes in low and high frequency configurations, respectively. As the graphene layer was connected to the GND conductors, a positive voltage applied to the signal pads corresponded to the negative bias of the graphene gate.

The interrupting gap between the parts **403, 404** was 20 µm. A smaller interrupting gap has an adverse impact on the isolation due to increased capacitive coupling between input and output. As a result, at frequencies above ~100 GHz switching is not effective.

In order to study the switching properties in the time domain the DC power supplier was replaced with the function generator. The switch according to the embodiment of the invention exhibits a very fast switching time. The rise and fall times are 25 ns and 17 ns, respectively. The use of such a switch can provide up to 20 MHz of bandwidth in time-modulated systems, which is the outstanding result for such systems.

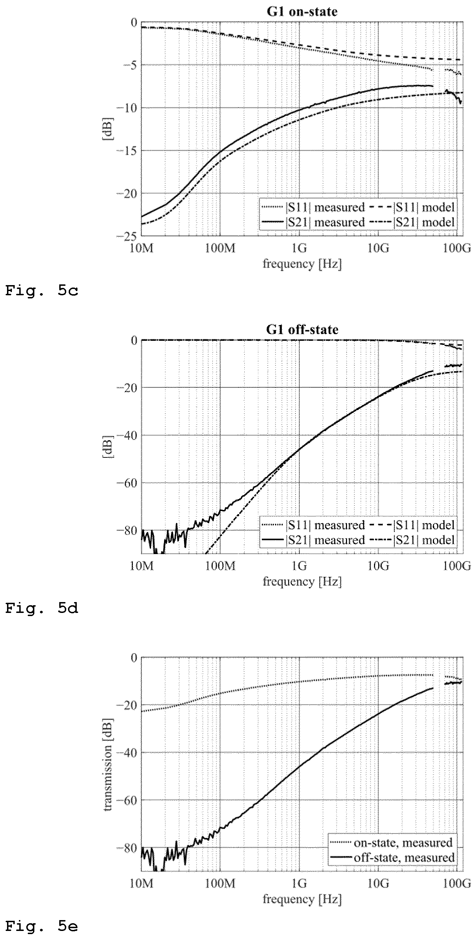

Results of simulation and measurement of the scattered parameters of the switch according to discussed embodiment of the invention are shown in Fig. 5c and Fig. 5d showing simulated and measured S11 and S21 in on and off state respectively.

The switch according to the invention which uses the combination of two-dimensional p type semiconductor and two-dimensional n-type semiconductor in the AlGaN/GaN system proved to be applicable for effective switching at RF frequencies. The switch was integrated into the coplanar waveguide, which was chosen due to lower losses compared to the microstrip line, especially at high frequencies. The presented design is an on-chip solution fabricated in one technological process. The switching times are sufficiently low to use this kind of the switch in time-modulated systems.

Fig. 5e shows comparison of transmission - S21 parameter - in on and off state of the switch.

The on-state insertion loss for the designed switches were measured to be from 7.4 to 19.4 dB, depending on frequency and switch design. Although at frequencies above 70 GHz the switches were less effective, the switching effect was still evident with approximately 4 dB on-off ratio.

Embodiment of the invention with field effect transistor comprising the combination of graphene and two dimensional high density electron gas (2DEG) in the AlGaN/GaN used in series to switch CPW allowed to switch effectively at RF and mm-wave frequencies. This approach allowed considerable reduction of problems with parasitic capacitances, packaging and interconnects, which can cause high losses, especially at mm-waves.

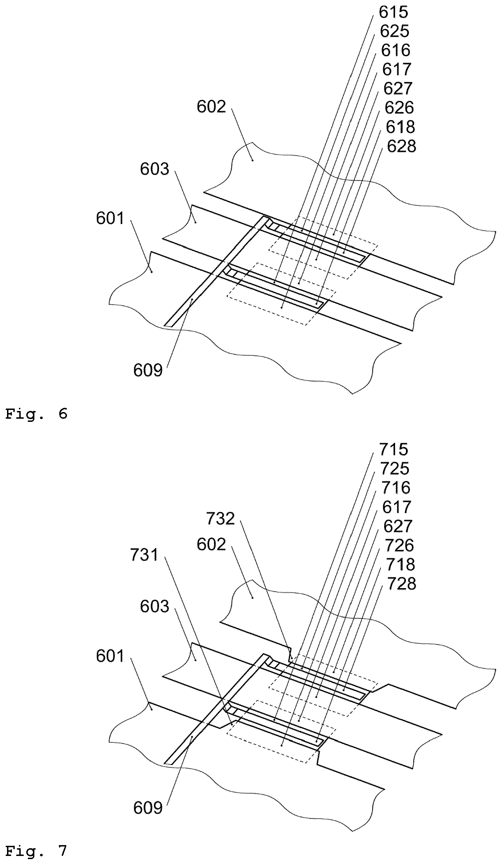

In the next embodiment of the switch according to the invention shown in Fig. 6 SHUNT configuration has been used. This switch is used also in CPW line having a first ground plane **601,** a second ground plane **602** and signal line **603.** In this configuration two transistors according to the invention are used to short-circuit the signal line to ground plane via low resistance of the spacing gap to interrupt propagation. A channel **615** of a first transistor is located between a source **616** of the first transistor and drain **617** of the first transistor. A channel **625** of a second transistor is located between a source **626** of the second transistor and drain **627** of the second transistor. Above the two-dimensional semiconducting channel, gates with two-dimensional semiconducting gate electrodes **618, 628** having opposite semiconducting type are provided. Control electrode **609** is isolated from the plane **601.** When negative potential is applied to electrode **609** then the channels **615, 625** are depleted, resistance of the spacing gaps between signal line and ground plane are high, and the structure allows transmission of the signal through the signal line - this is switch on-state. Simultaneously resistivity of gate electrodes **618, 628** made of two dimensional semiconductor having the opposite conductivity type increases. Accordingly decreases the impact that the gate electrodes **618, 628** have on characteristic impedance of the transmission line. That improves scattering parameters and reduces reflections. Biasing the transistors so as to enhance the channels results in low resistance of the spacing gap between the signal line **603** and the ground planes **601, 602** and consequently off-state.

Similar effect would be obtained if the transistor according to the invention was provided between the signal line **603** and only one of the planes **601, 602.** Using two transistors allows better isolation though.

It is possible to further improve the scattering parameters of the switch if spacing gaps between the signal line **603** and the ground planes **601,602** is increased to reduce parasitic capacitance, but narrowed down with flaps **731, 732** specifically in the areas where the channels **615, 625** are located, as shown in Fig. 7. This allows reducing the length of channels **715, 725** to improve isolation in off-state but only marginally affect transmission in the on-state especially if the signal line **603** is narrowed down too in the area in which the transistor is located (not shown in Fig. 7). The channel **715** of a first transistor is located between a source **716** of the first transistor extended with flap **731** and the drain **617** of the first transistor. The channel **725** of the second transistor is located between the source **726** of the first transistor extended with a flap **732** and drain **627** of the second transistor. Above the channel gates with two-dimensional semiconducting gate electrodes **718, 728** are provided narrowed down so as not to connect to ground plane or the signal line.

Person skilled in the art can easily use the other type of planar TEM lines and the transistor according to the invention to propose other embodiments of the switches according to the invention.

## Claims

1. A high frequency switch comprising a segment of high frequency transmission line having a first conductor and a second conductor, and comprising a transistor for selective changing of resistance of
either
an interrupting gap provided between a parts **(403, 404)** of the first conductor
or
a spacing gap between the first **(603)** conductor and the second conductor **(601,602),**
**characterized in that**
the transistor has
a source **(101, 210, 406, 616, 626, 716, 726)** and
a drain **(102, 211, 407, 617, 627)** connected via a two-dimensional semiconducting layer forming a channel **(103, 205, 405, 505, 615, 625)** having a first conductivity type,
a gate **(104, 105)** over the channel **(103, 205, 405, 505, 615, 625)** having gate electrode **(105, 209, 408, 618, 628, 718, 728)** and a gate insulator layer **(104)** provided between the gate electrode **(105, 209, 408, 618, 628, 718, 728)** and the channel **(103, 405, 615, 625, 715, 725),**
wherein the gate electrode **(105, 209, 408, 618, 628, 718, 728)** is a two-dimensional semiconductor having a second conductivity type opposite to the first conductivity type
and
the transistor is arranged so that the two-dimensional semiconducting channel **(405, 615, 625, 715, 725)** is disposed in
either
the interrupting gap provided between the parts **(403, 404)** of the first conductor
or
the spacing gap between the first conductor **(603)** and the second conductor **(601,602),**
while the two-dimensional semiconducting gate electrode **(408, 618, 628)** is disposed in the gap and is connected to control electrode **(409, 509, 510, 619, 629, 719, 729).**

2. High frequency switch according to claim 1, wherein the channel **(103, 205, 405, 505, 615, 625)** comprises electron gas **(205)** having n-conductivity type and the gate electrode **(105, 209, 408, 618, 628, 718, 728)** has a graphene layer **(209)** having p-conductivity type.

3. High frequency switch according to the claim 1 or 2, wherein the segment of the transmission line is a segment of coplanar line having a substrate and a signal line **(403, 404)** forming the first conductor and two ground planes **(401, 402)** forming the second conductor disposed on the substrate, wherein the signal line is interrupted with interrupting gap and split into a first part **(403)** and a second part **(404),** and wherein the transistor is integrated in the substrate of the segment of coplanar line below the interrupting gap so that the two-dimensional semiconductor gate electrode **(408)** is disposed above the interrupting gap, and has the control electrode **(409).**

4. High frequency switch according to the claim 3, wherein the two-dimensional semiconducting gate electrode **(408)** has two symmetrical control electrodes **(509, 510)** connected to both ground planes **(401,402).**

5. High frequency switch according to the claim 1 or 2, wherein the segment of transmission line is a segment of the coplanar transmission line having a substrate, a signal line **(603)** forming the first conductor and two ground planes **(601,602)** forming the second conductor wherein the signal line **(603)** is spaced by the spacing gaps from ground planes **(601, 602)** and the transistor is integrated in the substrate of the segment of coplanar line in the spacing gap between the signal line **(603)** and at least one ground plane **(601,602)** while the two-dimensional semiconductor channel **(615,625)** is disposed between the signal line **(603)** and the at least one of the ground planes **(601,602),** wherein above the two-dimensional semiconducting channel **(615,625),** the two-dimensional semiconducting gate electrode **(618,628)** having opposite conductivity type is provided.

6. High frequency switch according to the claim 5, **characterized in that** the two transistors are applied for short-circuiting the signal line **(603)** to both ground planes **(601,602)** simultaneously.

7. High frequency switch according to the claims 6 or 7 wherein the spacing gaps and/or the signal line **(603)** are narrowed down in the area in which the transistor is located.
